# EUROPÄISCHE PATENTSCHRIFT

(11) **EP 3 482 463 B1**
(45) Veröffentlichungstag und Bekanntmachung des Hinweises auf die Patenterteilung: **08.04.2020**
(21) Anmeldenummer: 18704522.4
(22) Anmeldetag: 08.02.2018
(51) Int. Cl.: H01R 13/03, H01R 13/24, H01R 43/16

(54) **ELEKTRISCHES KONTAKTELEMENT**
ELECTRICAL CONTACT ELEMENT
ÉLÉMENT DE CONTACT ÉLECTRIQUE

(30) Priorität: 06.03.2017 DE 102017002150
(43) Veröffentlichungstag der Anmeldung: 15.05.2019
(73) Patentinhaber: Rosenberger Hochfrequenztechnik GmbH & Co. KG, 83413 Fridolfing (DE)
(72) Erfinder: HUBER, Ludwig, 83413 Fridolfing (DE); REISCHL, Stefan, 83404 Ainring (DE)
(86) Internationale Anmeldenummer: PCT/EP2018/053160
(87) Internationale Veröffentlichungsnummer: WO 2018/162166

(56) Entgegenhaltungen:
- EP-A2- 0 941 020
- WO-A1-2016/146451
- US-A- 3 525 066

## Beschreibung

### GEBIET DER ERFINDUNG

Die vorliegende Erfindung betrifft ein elektrisches Kontaktelement.

### TECHNISCHER HINTERGRUND

Elektrische Kontaktelemente dienen zur elektrischen Verbindung von jeweils zwei Kontaktflächen, die auf zwei unterschiedlichen elektrischen bzw. elektronischen Komponenten, beispielsweise auf einer Leiterplatte, einer integrierten Schaltung oder einem Stecker, aufgebracht sind.

Aus der WO 2016/146451 A1 ist ein elektrisches Kontaktelement mit einem Grundkörper bekannt. Zur Erhöhung der Abriebfestigkeit im Kontaktierungsbereich ist das Material des Grundkörpers im Kontaktierungsbereich durch ein härteres Material ersetzt.

Ein elektrisches Kontaktelement ist üblicherweise aus einem Grundkörper aus einem vergleichsweise harten Grundmaterial, beispielsweise aus Metall oder Keramik, und einer auf dem Grundkörper aufgebrachten Beschichtung aus einem vom Grundmaterial abweichendem Beschichtungsmaterial aufgebaut. Das Grundmaterial weist eine gewisse Härte im Hinblick auf die mechanische Stabilität des Kontaktelements auf. Da die Beschichtung des elektrischen Kontaktelements die technische Funktion der elektrischen Kontaktierung übernimmt, kann als Beschichtungsmaterial ein vergleichsweise weiches Material verwendet werden. Das Beschichtungsmaterial soll eine gute elektrische Leitfähigkeit und darüber hinaus eine hohe Korrosionsbeständigkeit aufweisen. Als Beschichtungsmaterial wird typischerweise Gold verwendet. Darüber hinaus kommen aber auch beispielsweise Silber, Ruthenium und Rhodium als Beschichtungsmaterial zum Einsatz.

Ein Kontaktelement mit einer Goldbeschichtung ist beispielsweise aus der US 3,525,066 A bekannt.

Werden elektrische Kontaktelemente beispielsweise in Testsockeln eingesetzt, in die zu prüfende integrierte Schaltungen eingesetzt werden, so kommt es bei jedem Einsetzen einer zu prüfenden integrierten Schaltung in den Sockel zu einer geringfügigen planparallelen Bewegung des Kontaktbereiches des elektrischen Kontaktelements an der zu kontaktierenden Kontaktfläche der integrierten Schaltung. Diese planparallele Bewegung des Kontaktbereichs des Kontaktelements an der zugehörigen Kontaktfläche der integrierten Schaltung führt im Laufe der Zeit zu einem unerwünschten Abtrag des Beschichtungsmaterials im Kontaktbereich des Kontaktelements. Dieser Abtrag des Beschichtungsmaterials im Kontaktbereich des Kontaktelements erhöht nachteilig den elektrischen Übergangswiderstand des elektrischen Kontaktelements im Kontaktbereich und damit die elektrische Kontaktierung zwischen dem elektrischen Kontaktelement und der zugehörigen Kontaktfläche der zu prüfenden integrierten Schaltung.

Bei einem elektrischen Kontaktelement nach dem Stand der Technik reduziert sich das Beschichtungsmaterial nach dem Abtragvorgang auf der neu entstandenen Kontaktfläche einzig auf die dünnen Randflächenbereiche, die zu den zur Kontaktfläche seitlichen Beschichtungen des Kontaktelements gehören. Da diese Randflächenbereiche mit Beschichtungsmaterial vergleichsweise sehr gering sind, verschlechtert sich der elektrische Übergangswiderstand des elektrischen Kontaktelements im abgeschabten Kontaktbereich deutlich.

Dies ist ein Zustand, den es zu verbessern gilt.

### ZUSAMMENFASSUNG DER ERFINDUNG

Vor diesem Hintergrund liegt der vorliegenden Erfindung die Aufgabe zugrunde, ein elektrisches Kontaktelement anzugeben, das über eine möglichst lange Betriebsdauer gleichbleibend gute physikalische Eigenschaften aufweist.

Erfindungsgemäß wird diese Aufgabe durch ein elektrisches Kontaktelement mit den Merkmalen des Patentanspruchs 1 gelöst.

### Demgemäß ist vorgesehen:

Ein elektrisches Kontaktelement, das mehrere Kontaktbereiche mit jeweils einer Kontaktfläche aufweist, mit einem Grundkörper aus einem ersten Material und einer auf dem ganzen Grundkörper aufgebrachten Beschichtung aus einem Beschichtungsmaterial, wobei in mindestens einem Bereich des Grundkörpers innerhalb von mindestens einem Kontaktbereich jeweils das erste Material entfernt ist und zumindest teilweise durch ein zweites Material ersetzt ist. Das zweite Material und das Beschichtungsmaterial weisen jeweils eine gegenüber dem ersten Material höhere elektrische Leitfähigkeit und eine gegenüber dem ersten Material geringere Härte auf.

Unter einem Kontaktbereich des elektrischen Kontaktelements wird hierbei und im Folgenden derjenige Bereich des elektrischen Kontaktelements verstanden, der mit einem elektrisch leitfähigen Bereich, insbesondere mit einer elektrisch leitfähigen Kontaktfläche, eines zu kontaktierenden elektrischen oder elektronischen Bauelements, einer zu kontaktierenden elektrischen oder elektronischen Baugruppe oder einer zu kontaktierenden elektrischen oder elektronischen Funktionseinheit eines elektronischen Systems in einem elektrischen Kontakt steht. Unter Kontaktbereich fällt hierbei nicht nur die direkte Kontaktierungsfläche des Kontaktelements, sondern auch der zur direkten Kontaktierungsfläche unmittelbar benachbarte Bereich des Kontaktelements.

Kommt es aufgrund des Abtragvorgangs nach einer bestimmten Anzahl von Steckzyklen zu einer Entfernung der Beschichtung in einem Kontaktbereich, insbesondere auf der Kontaktfläche innerhalb des Kontaktbereiches, des elektrischen Kontaktelements, so bildet sich eine neue Kontaktfläche im Kontaktbereich des elektrischen Kontaktelements. Diese neue Kontaktfläche weist mindestens einen Flächenbereich auf, in dem das erste Material durch das zweite Material ersetzt ist. Die zumindest teilweise Ersetzung des ersten Materials durch das zweite Material im Kontaktbereich des elektrischen Kontaktelements vergrößert somit gegenüber einem Kontaktelement nach dem Stand der Technik den Kontaktflächenbereich, der aus einem Material mit einer gegenüber dem ersten Material höheren elektrischen Leitfähigkeit hergestellt ist. Vorteilhaft wird somit im Fall des Abtrags der Beschichtung eine Verbesserung des elektrischen Übergangswiderstandes im Kontaktbereich des elektrischen Kontaktelements gegenüber einem elektrischen Kontaktelement nach dem Stand der Technik erzielt.

Vorteilhafte Ausgestaltungen und Weiterbildungen ergeben sich aus den weiteren Unteransprüchen sowie aus der Beschreibung unter Bezugnahme auf die Figuren der Zeichnung.

Es versteht sich, dass die voranstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

In einer ersten Ausprägung der Erfindung entspricht das zweite Material dem Beschichtungsmaterial. In diesem Fall enthält die durch Abrieb neu entstehende Kontaktfläche nicht nur die dünnen Randflächenbereiche der Beschichtung mit Beschichtungsmaterial, sondern auch Flächenbereiche innerhalb des Grundkörpers mit Beschichtungsmaterial. Diese Flächenbereiche der durch Abtrag neu entstandenen Kontaktfläche weisen somit einen geringeren elektrischen Übergangswiderstand als die übrigen Flächenbereiche der durch Abtrag neu entstandenen Kontaktfläche auf, die erstes Material, d.h. das Grundmaterial des Grundkörpers, enthalten.

In einer zweiten Ausprägung der Erfindung entspricht das zweite Material einem zum Beschichtungsmaterial unterschiedlichen Material. Da auch dieses zum Beschichtungsmaterial unterschiedliche Material eine höhere elektrische Leitfähigkeit als das erste Material aufweist, enthält die durch Abrieb neu entstandene Kontaktfläche Flächenbereiche mit einem geringeren elektrischen Übergangswiderstand. Diese Flächenbereiche setzen sich aus den dünnen Randflächenbereichen der Beschichtung mit Beschichtungsmaterial und den Flächenbereichen innerhalb des Grundkörpers mit einem zum Beschichtungsmaterial unterschiedlichen zweiten Material zusammen. Die das erste Material aufweisenden Flächenbereiche innerhalb des Grundköpers stellen die Flächenbereiche mit einem höheren elektrischen Übergangswiderstand dar.

Die zweite Ausprägung der Erfindung ermöglicht gegenüber der ersten Ausprägung der Erfindung die Verwendung eines zweiten Materials mit einer gegenüber dem Beschichtungsmaterial höheren elektrischen Leitfähigkeit. Auf diese Weise kann der elektrische Übergangswiderstand bei einer durch Abtrag neu entstandenen Kontaktfläche an den elektrischen Übergangswiderstand einer zugehörigen, nicht abgeriebenen Kontaktfläche angepasst oder zumindest mit kleinstmöglichen Verlusten verwirklicht werden.

Sowohl die erste Ausprägung der Erfindung als auch die zweite Ausprägung der Erfindung ermöglicht bevorzugt die Realisierung einer durch Abtrag neu entstandenen Kontaktfläche, die Flächenbereiche aus zweiten Material und aus Beschichtungsmaterial enthält, die in Summe gegenüber den summierten Flächenbereichen der Beschichtung innerhalb der durch Abrieb neu entstandenen Kontaktfläche vergrößert sind. Somit ergibt sich gegenüber einem elektrischen Kontaktelement nach dem Stand der Technik eine durch Abtrag neu entstandene Kontaktfläche eines erfindungsgemäßen Kontaktelements, die vorteilhaft in Summe größere Flächenbereiche mit einem niedrigeren elektrischen Übergangswiderstand aufweist.

In einer ersten Ausführungsform des erfindungsgemäßen Kontaktelements ist der mindestens eine Bereich des Grundkörpers innerhalb des einzelnen Kontaktbereiches, in dem das erste Material zumindest teilweise durch ein zweites Material mit einer gegenüber dem ersten Material höheren elektrischen Leitfähigkeit ersetzt ist, jeweils als Sacklochbohrung oder als Durchgangsbohrung realisiert.

Unter einer Durchgangsbohrung wird in diesem Zusammenhang und im Folgenden eine Bohrung verstanden, die sich innerhalb des Kontaktbereiches des Kontaktelements von einer Außenfläche zu einer gegenüberliegenden Außenfläche des Kontaktelements erstreckt.

Unter einer Sacklochbohrung wird in diesem Zusammenhang und im Folgenden eine Bohrung verstanden, die sich innerhalb des Kontaktbereiches des Kontaktelements von einer Außenfläche des Kontaktelements bis zu einem Bereich im Innern des Kontaktelements, d.h. im Grundkörper des Kontaktelements, erstreckt und dort endet.

In beiden Fällen - Durchgangsbohrung und Sacklochbohrung - kann es sich jeweils um eine Bohrung mit einem kreisförmigen Querschnittsprofil, eine sogenannte Rundlochbohrung, oder um eine Bohrung mit einem länglichen Querschnittsprofil, eine sogenannte Langlochbohrung, handeln. Daneben sind aber auch Bohrungen mit einem anderen Querschnittsprofil, beispielsweise mit einem quadratischen oder einem rechteckförmigen Querschnittsprofil, mit abgedeckt.

In einer ersten Untervariante der ersten Ausführungsform ist die Bohrung vollständig mit zweitem Material ausgefüllt. In einer zweiten Untervariante der ersten Ausführungsform ist die Bohrung nur teilweise mit dem zweiten Material ausgefüllt, insbesondere ist die Innenwandung der Bohrung mit dem zweiten Material beschichtet. Die durch Abtrag neu entstehende Kontaktfläche im Kontaktbereich des elektrischen Kontaktelements weist bei der ersten Untervariante gegenüber der zweiten Untervariante einen vergleichsweise größeren Flächenanteil mit zweitem Material auf und besitzt somit einen geringeren elektrischen Übergangswiderstand.

Die zumindest teilweise mit zweitem Material versehenen Bohrungen innerhalb des jeweiligen Kontaktbereichs des elektrischen Kontaktelements können, wie noch weiter unten dargestellt wird, bestimmte Orientierungen innerhalb des Kontaktelements und relativ zur ursprünglichen Kontaktfläche im jeweiligen Kontaktbereich des Kontaktelements aufweisen.

In einer zweiten Ausführungsform der Erfindung ist der mindestens eine Bereich im Grundkörper innerhalb des jeweiligen Kontaktbereiches des elektrischen Kontaktelements, in dem das erste Material zumindest teilweise durch ein zweites Material mit einer gegenüber dem ersten Material höheren elektrischen Leitfähigkeit ersetzt ist, jeweils ein Schlitz, der sich durch die Beschichtung in den Grundkörper hineinerstreckt.

Unter einem Schlitz wird hierbei und im Folgenden eine Ausnehmung ausgehend von der ursprünglichen Kontaktfläche im jeweiligen Kontaktbereich des elektrischen Kontaktelements mit einer bestimmten Schlitztiefe und einer bestimmten Schlitzbreite verstanden, die sich von einer an die ursprüngliche Kontaktfläche angrenzenden Außenfläche zur jeweils gegenüberliegenden Außenfläche des Kontaktelements erstreckt.

Hierbei ist der einzelne Schlitz in einer ersten Untervariante der zweiten Ausführungsform vollständig mit zweitem Material gefüllt. In einer zweiten Untervariante der zweiten Ausführungsform ist der einzelne Schlitz nur teilweise mit zweitem Material gefüllt. Insbesondere sind in der zweiten Untervariante einzig die Innenwände des einzelnen Schlitzes mit einem zweiten Material beschichtet.

In einer dritten Ausführungsform der Erfindung ist der mindestens eine Bereich im Grundkörper innerhalb des jeweiligen Kontaktbereichs des elektrischen Kontaktelements, in dem das erste Material durch ein zweites Material mit einer gegenüber dem ersten Material höheren elektrischen Leitfähigkeit ersetzt ist, jeweils als einzig innerhalb des Grundkörpers im jeweiligen Kontaktbereich des elektrischen Kontaktelements befindlicher dreidimensionaler Körper realisiert. Dies kann ein kugelförmiger, quaderförmiger, ellipsoid-förmiger, kubischer oder sonstig geformter regulärer Körper sein. Alternativ kann der einzig innerhalb des Grundkörpers im jeweiligen Kontaktbereich des elektrischen Kontaktelements befindliche dreidimensionale Körper aus zweitem Material auch jede andere mögliche irreguläre Form aufweisen. Liegen mehrere derartige dreidimensionale Körper aus zweitem Material innerhalb des Grundkörpers im jeweiligen Kontaktbereich des Kontaktelements vor, so können diese Körper aus zweitem Material entweder stochastisch ungeordnet oder auch in einer bestimmten Ordnungsstruktur, beispielsweise in einem Raster, zueinander angeordnet sein.

In einer vierten Ausführungsform der Erfindung ist der mindestens eine Bereich im Grundkörper innerhalb des jeweiligen Kontaktbereiches des elektrischen Kontaktelements, in dem das erste Material durch ein zweites Material mit einer zum ersten Material höheren elektrischen Leitfähigkeit ersetzt ist, jeweils eine Schicht mit einer bestimmten Schichtdicke, die sich entsprechend ihrer Orientierung im Kontaktelement zumindest über den gesamten jeweiligen Kontaktbereich erstreckt. In einer bevorzugten Erweiterung der vierten Ausführungsform erstreckt sich die einzelne Schicht entsprechend ihrer Orientierung im Kontaktelement über die gesamte Ausdehnung des elektrischen Kontaktelements. Die einzelne Schicht ist hierbei bevorzugt vollständig aus zweitem Material hergestellt. Liegen mehrere Schichten aus zweitem Material vor, so sind diese Schichten zueinander parallel orientiert. Eine bevorzugte Orientierung einer derartigen Schicht erfolgt in der Ebene der beiden Haupterstreckungsrichtungen des elektrischen Kontaktelements. Alternativ können derartige Schichten aus zweitem Material auch senkrecht zur Ebene der beiden Haupterstreckungsrichtungen des elektrischen Kontaktelements orientiert sein.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNG

Die vorliegende Erfindung wird nachfolgend anhand der in den schematischen Figuren der Zeichnung angegebenen Ausführungsbeispiele näher erläutert. Es zeigen dabei:
- Fig. 1: eine Darstellung eines elektrischen Kontaktelements nach dem Stand der Technik,
- Fig. 2A: eine Darstellung einer ersten Ausprägung einer ersten Untervariante einer ersten Ausführungsform eines erfindungsgemäßen elektrischen Kontaktelements mit Teilquerschnittsdarstellung,
- Fig. 2B: eine Darstellung einer zweiten Ausprägung einer ersten Untervariante einer ersten Ausführungsform eines erfindungsgemäßen elektrischen Kontaktelements mit Teilquerschnittsdarstellung,
- Fig. 2C: eine Darstellung einer ersten Ausprägung einer zweiten Untervariante einer ersten Ausführungsform eines erfindungsgemäßen elektrischen Kontaktelements mit Teilquerschnittsdarstellung,
- Fig. 2D: eine Darstellung einer zweiten Ausprägung einer zweiten Untervariante einer ersten Ausführungsform eines erfindungsgemäßen elektrischen Kontaktelements mit Teilquerschnittsdarstellung,
- Fig. 2E: eine Darstellung einer weiteren zweiten Ausprägung einer zweiten Untervariante einer ersten Ausführungsform eines erfindungsgemäßen elektrischen Kontaktelements mit Teilquerschnittsdarstellung,
- Fig. 2F: eine Darstellung einer dritten Ausprägung einer ersten Untervariante einer ersten Ausführungsform eines erfindungsgemäßen elektrischen Kontaktelements mit Teilquerschnittsdarstellung,
- Fig. 2G: eine Darstellung einer dritten Ausprägung einer zweiten Untervariante einer ersten Ausführungsformeines erfindungsgemäßen elektrischen Kontaktelements mit Teilquerschnittsdarstellung,
- Fig. 2H: eine Darstellung einer vierten Ausprägung einer ersten Untervariante einer ersten Ausführungsform eines erfindungsgemäßen elektrischen Kontaktelements mit Teilquerschnittsdarstellung,
- Fig. 2I: eine Darstellung einer vierten Ausprägung einer zweiten Untervariante einer ersten Ausführungsform eines erfindungsgemäßen elektrischen Kontaktelements mit Teilquerschnittsdarstellung,
- Fig. 2J: eine Darstellung einer fünften Ausprägung einer ersten Untervariante einer ersten Ausführungsform eines erfindungsgemäßen elektrischen Kontaktelements mit Teilquerschnittsdarstellung,
- Fig. 3A: eine Darstellung einer ersten Untervariante einer zweiten Ausführungsform eines erfindungsgemäßen elektrischen Kontaktelements mit Teilquerschnittsdarstellung,
- Fig. 3B: eine Darstellung einer zweiten Untervariante einer zweiten Ausführungsform eines erfindungsgemäßen elektrischen Kontaktelements mit Teilquerschnittsdarstellung,
- Fig. 4: eine Darstellung einer dritten Ausführungsform eines erfindungsgemäßen elektrischen Kontaktelements mit Teilquerschnittsdarstellung,
- Fig. 5A: eine Darstellung einer vierten Ausführungsform eines erfindungsgemäßen elektrischen Kontaktelements mit Teilquerschnittsdarstellung und
- Fig. 5B: eine Darstellung einer vierten Ausführungsform eines erfindungsgemäßen elektrischen Kontaktelements ohne stirnseitige Beschichtung.

Die beiliegenden Figuren der Zeichnung sollen ein weiteres Verständnis der Ausführungsformen der Erfindung vermitteln. Sie veranschaulichen die einzelnen Ausprägungen, Untervarianten und Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

Im Folgenden werden die Figuren zusammenhängend und übergreifend beschrieben.

### BESCHREIBUNG VON AUSFÜHRUNGSBEISPIELEN

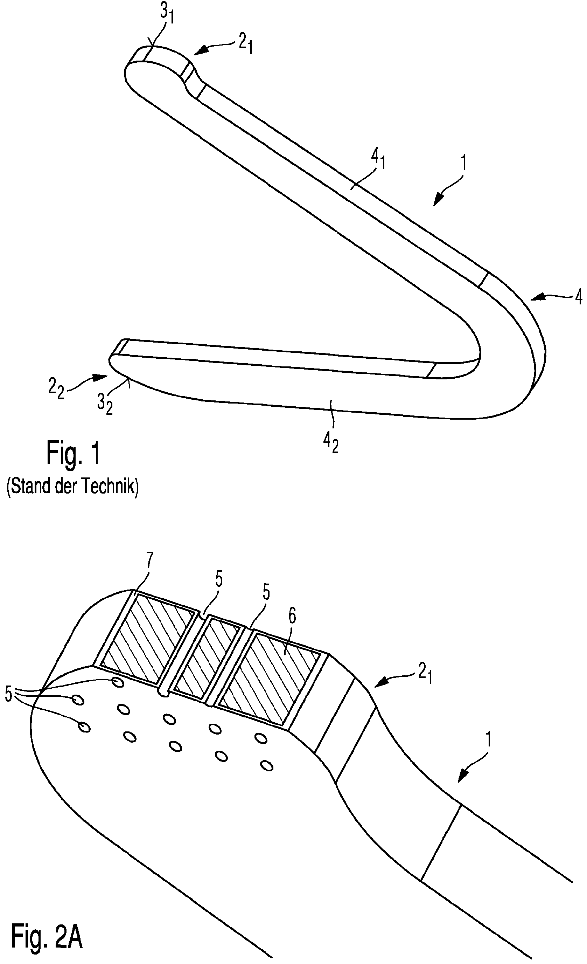

Im Folgenden wird zuerst anhand von Fig. 1 der prinzipielle Aufbau eines beispielhaften Kontaktelements erläutert:
Ein elektrisches Kontaktelement 1 weist bevorzugt zwei Kontaktbereiche 2₁ und 2₂ auf. Jeder dieser beiden Kontaktbereiche 2₁ und 2₂ weist jeweils eine Kontaktfläche 3₁ bzw. 3₂ auf, die jeweils zur elektrischen Kontaktierung mit einer Kontaktfläche einer zugehörigen, zu kontaktierenden elektrischen oder elektronischen Komponente dient. Über das elektrische Kontaktelement erfolgt somit eine elektrische Verbindung zwischen den Kontaktflächen der beiden zu kontaktieren elektrischen oder elektronischen Komponenten. Sowohl die elektrische oder elektronischen Komponenten als auch die zugehörigen Kontaktflächen sind in Fig. 1 und in allen nachfolgenden Figuren nicht dargestellt.

Daneben kann das elektrische Kontaktelement 1 auch mehr als zwei Kontaktbereiche und zugehörige Kontaktflächen aufweisen, was durch die Erfindung mit abgedeckt ist. Auf diese Weise können mehr als zwei Kontaktflächen über dasselbe Kontaktelement miteinander elektrisch verbunden werden. Alternativ kann auf diese Weise eine Kontaktfläche parallel durch mehrere Kontaktbereiche des elektrischen Kontaktelements kontaktiert werden.

Die mechanische und elektrische Verbindung der beiden Kontaktbereiche 2₁ und 2₂ erfolgt durch einen Verbindungsbereich 4. Da der Abstand zwischen den beiden elektrischen oder elektronischen Komponenten im Allgemeinen einer gewissen Schwankung unterworfen ist, weist der Verbindungsbereich 4 bevorzugt eine gewisse Elastizität auf. Auf diese Weise ist eine sichere elektrische Verbindung zwischen den beiden elektrischen oder elektronischen Komponenten über das elektrische Kontaktelement 1 gewährleistet.

Die Elastizität des Verbindungsbereiches 4 wird, wie in Fig. 1 dargestellt ist, durch zwei Federarme 4₁ und 4₂ realisiert. Jeder Federarm 4₁ und 4₂ weist an seinem einen Ende jeweils einen Kontaktbereich 2₁ bzw. 2₂ auf bzw. ist an seinem einen Ende jeweils mit einem Kontaktbereich 2₁ bzw. 2₂ verbunden. Die beiden Federarme 4₁ und 4₂ sind jeweils an ihrem anderen Ende miteinander verbunden.

Alternativ kann der Verbindungsbereich 4 auch als einziger Federarm (englisch: cantilever), als elastischer Knickstab (englisch: buckling beam) realisiert sein.

Neben diesen eine Elastizität aufweisenden elastischen Kontaktelementen sind von der Erfindung auch nicht elastische Kontaktelemente mit abgedeckt. Bei derartigen nicht elastischen Kontaktelementen sind die einzelnen Kontaktbereiche jeweils über einen starren Verbindungsbereich miteinander verbunden. Um einen variablen Abstand zwischen den Kontaktflächen der beiden zu kontaktierenden elektrischen oder elektronischen Komponenten auszugleichen, wird die Elastizität mittels eines zusätzlichen elastischen Bauteils erzielt, das mit dem starren Kontaktelement in Verbindung steht. Das elastische Bauteil kann beispielsweise eine auf das Kontaktelement wirkende Feder eines Federkontaktstiftes oder ein auf das Kontaktelement wirkendes Bauteil aus Elastomer sein.

Neben der in Fig. 1 dargestellten Ausführung eines elektrischen Kontaktelements 1 sind von der Erfindung alle technisch sinnvollen geometrischen Formen eines elastischen oder nicht elastischen Kontaktelements mit jeweils mehreren Kontaktbereichen mit abgedeckt. Die verwendete geometrische Form hängt sehr stark von den mechanischen und elektrischen Anforderungen der jeweiligen technischen Anwendung des elektrischen Kontaktelements ab. Das Spektrum reicht hierbei von elektrischen Kontaktierungen für Gleichstrom- bzw. Niederfrequenzanwendungen bis zu hoch aufwendigen elektrischen Kontaktierungen für Hochfrequenzanwendungen, inclusive Koaxialsteckern.

Auch die Größenordnung eines elastischen oder nicht elastischen Kontaktelements kann sich von vergleichsweise großen Abmessungen für beispielsweise Hochstrom- bzw. Hochspannungsanwendungen bis zu mikromechanischen Ausdehnungen für Kontaktelemente zur Kontaktierung von hoch integrierten Halbleiterkomponenten erstrecken. Entsprechend unterschiedlich sind die zur Herstellung des jeweiligen elektrischen Kontaktelements anwendbaren Fertigungstechnologien. Diese erstrecken sich von Zerspanungs- und Gusstechniken für voluminöse Kontaktelemente bis zu Aufbautechnologien, beispielsweise in LIGA-Technik, für mikromechanische Kontaktelemente. Alle genannten Kontaktelemente, die von der Erfindung mit abgedeckt sind, sind bevorzugt aus einem Grundkörper aus einem beispielsweise metallischen oder keramischen Grundmaterial, das im Folgenden als erstes Material bezeichnet wird, und einer auf dem Grundkörper aufgebrachten Beschichtung aus einem Beschichtungsmaterial hergestellt. Als erstes Material wird ein Material mit einer im Vergleich zum Beschichtungsmaterial höheren Materialhärte, beispielsweise Kupferberyllium oder Federstahl, verwendet, um eine gewisse mechanische Mindeststabilität des Kontaktelements zu erzielen. Als Beschichtungsmaterial kommt ein vergleichsweise weicheres Material zum Einsatz, das eine gute elektrische Leitfähigkeit und gleichzeitig eine hohe Korrosionsbeständigkeit aufweist. Hierfür wird bevorzugt Gold, aber auch Silber, Ruthenium oder Rhodium eingesetzt. Um einen geringen elektrischen Übergangswiderstand entlang des gesamten Kontaktelements, eine hohe Korrosionsbeständigkeit über die gesamte Oberfläche des elektrischen Kontaktelements und eine möglichst einfache Realisierung der Beschichtung zu verwirklichen, wird der gesamte Grundkörper des elektrischen Kontaktelements mit einer Beschichtung versehen.

Ausgehend von diesem Grundaufbau eines elektrischen Kontaktelements 1 wird erfindungsgemäß in mindestens einem Bereich innerhalb mindestens eines Kontaktbereichs das erste Material des Grundkörpers zumindest teilweise durch ein zweites Material mit einer gegenüber dem ersten Material höheren elektrischen Leitfähigkeit ersetzt. Das zweite Material entspricht, wie bereits erwähnt wurde, in einer ersten Ausprägung der Erfindung dem Beschichtungsmaterial und ist in einer zweiten Ausprägung der Erfindung ein zum Beschichtungsmaterial unterschiedliches Material.

Falls es zum Abtrag der Beschichtung an der Kontaktfläche 3₁ bzw. 3₂ in mindestens einem Kontaktbereich 2₁ und 2₂ infolge einer Vielzahl von Steckzyklen kommt, bildet sich im jeweiligen Kontaktbereich 2₁ und 2₂ jeweils eine neue Kontaktfläche. Diese neue Kontaktfläche weist nicht nur wie bei einem elektrischen Kontaktelement nach dem Stand der Technik an ihren Rändern jeweils Beschichtungsmaterial auf, die zur Beschichtung der zur neuen Kontaktfläche benachbarten Außenflächen des elektrischen Kontaktelements gehören. Vielmehr dringt in der neuen Kontaktfläche der mindestens eine Bereich des Grundkörpers an die Außenoberfläche des elektrischen Kontaktelements, in dem das erste Material zumindest teilweise durch das zweite Material ersetzt ist. Auf diese Weise vergrößern sich bei einem erfindungsgemäßen elektrischen Kontaktelement in der neuen Kontaktfläche die Flächenbereiche mit jeweils einem gegenüber dem ersten Material, d.h. dem Grundmaterial des Grundkörpers, höheren elektrischen Leitfähigkeit gegenüber einem elektrischen Kontaktelement nach dem Stand der Technik. Somit wird trotz eines Abtrags der Beschichtung der elektrische Übergangswiderstand des erfindungsgemäßen elektrischen Kontaktelements im jeweiligen Kontaktbereich gegenüber dem Stand der Technik vorteilhaft verbessert.

In einer ersten Ausführungsform des erfindungsgemäßen Kontaktelements sind die Bereiche, in denen das erste Material des Grundkörpers zumindest teilweise durch das zweite Material ersetzt ist, jeweils durch eine Durchgangs- oder Sacklochbohrung realisiert.

Aus Fig. 2A gehen mehrere Durchgangsbohrungen 5 hervor, die in einem Kontaktbereich 2₁ von einer Außenfläche des elektrischen Kontaktelements 1 durch den schraffiert dargestellten Grundkörper 6 des elektrischen Kontaktelements 1 zur gegenüberliegenden Außenfläche des elektrischen Kontaktelements 1 sich erstrecken und dabei im jeweiligen Außenflächenbereich die nicht schraffiert dargestellten Beschichtung 7 durchdringen.

Bevorzugt sind im jeweiligen Kontaktbereich 2₁ bzw. 2₂ jeweils mehrere Durchgangsbohrungen 5 vorgesehen. Die Anordnung und die Abstände der einzelnen Durchgangsbohrungen 5 sind so gewählt, dass im jeweiligen Kontaktbereich 2₁ bzw. 2₂ einerseits ausreichend erstes Material zur mechanischen Stabilisierung des elektrischen Kontaktelements 1 und andererseits möglichst viel zweites Material zur Verbesserung des elektrischen Übergangswiderstandes an den neuen Kontaktflächen im Fall von Abtrag vorliegt.

Alternativ ist aber auch die Realisierung einer einzigen Durchgangsbohrung 5 durch den Grundkörper 6, die bevorzugt mittig zur jeweiligen Kontaktfläche 3₁ bzw. 3₂ angeordnet ist, möglich und von der Erfindung mit abgedeckt.

In der in Fig. 2A dargestellten ersten Untervariante einer ersten Ausführungsform des erfindungsgemäßen elektrischen Kontaktelements 1 ist das erste Material des Grundkörpers 6 in den einzelnen Durchgangsbohrungen 5 jeweils nur teilweise durch ein zweites Material ersetzt, indem die Innenwandung der einzelnen Durchgangsbohrung 5 jeweils mit dem zweiten Material beschichtet ist. Wird als zweites Material Beschichtungsmaterial verwendet, ist in diesem Fall das Einfügen von Beschichtungsmaterial in die einzelnen Durchgangsbohrungen 5 einzig durch einen Beschichtungsvorgang realisierbar. Dies stellt die fertigungstechnisch einfachste Realisierungsvariante dar.

Bei der in Fig. 2A dargestellten Untervariante einer ersten Ausführungsform des erfindungsgemäßen elektrischen Kontaktelements 1, bei dem das erste Material des Grundkörpers 6 in den einzelnen Durchgangsbohrungen 5 jeweils nur teilweise durch ein zweites Material ersetzt ist, sind auch die Bereiche der Beschichtung 7 an den beiden Außenflächen des erfindungsgemäßen elektrischen Kontaktelements 1, die an die von zweitem Materialbefreite Bereiche der Durchgangsbohrung 5 anschließen, nicht mit Beschichtungsmaterial ausgefüllt.

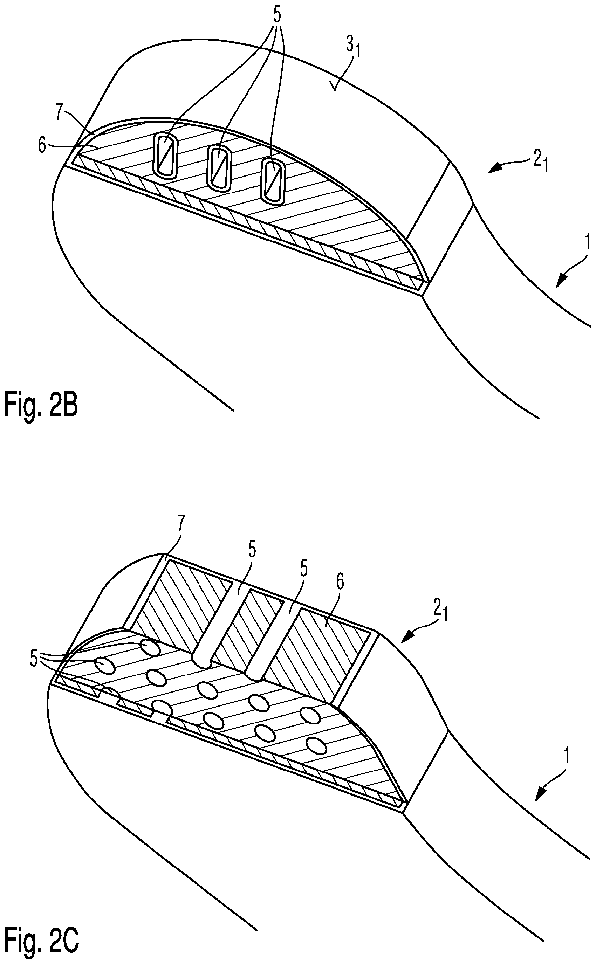

Um nach einem Abtrag der ursprünglichen Kontaktflächen 3₁ bzw. 3₂ einen geringeren elektrischen Übergangswiderstand an den neuen Kontaktflächen zu erzielen, sind in einer zweiten Untervariante der ersten Ausführungsform des erfindungsgemäßen elektrischen Kontaktelements 1 gemäß Fig. 2C die einzelnen Durchgangsbohrungen 5 jeweils vollständig mit einem zweiten Material ausgefüllt. Eine Realisierung eines derartigen Kontaktelements 5 ist deutlich aufwendiger. Ist ein mikromechanisches Kontaktelement herzustellen, so bietet sich hierfür eine Aufbautechnologie, beispielsweise die Lithographie- Galvanik-Abformung(LIGA)-Technologie, an.

Bevorzugt sind in beiden Untervarianten die einzelnen Durchgangsbohrungen 5 in einer bestimmten regulären Anordnung, d.h. in einem bestimmten Raster, zueinander angeordnet. Hierbei sind die einzelnen Durchgangsbohrungen 5 zwischen den einzelnen Ebenen, welche parallel zur Kontaktfläche 3₁ und 3₂ im jeweiligen Kontaktbereich 2₁ bzw. 2₂ verlaufen, bevorzugt jeweils versetzt zueinander angeordnet. Somit ist gewährleistet, dass über die gesamte Betriebsdauer des elektrischen Kontaktelements 1, d.h. in jeder Phase des Abriebs des Kontaktbereichs, die jeweils neu entstehende Kontaktfläche im jeweiligen Kontaktbereich näherungsweise immer das gleiche Verhältnis zwischen summierten Kontaktflächenbereichen aus ersten Material und summierten Kontaktflächenbereichen aus zweitem Material und aus Beschichtungsmaterial enthält. Somit bleibt der elektrische Übergangswiderstand über alle durch einen Abtrag jeweils neu entstandenen Kontaktflächen innerhalb eines Kontaktbereichs jeweils näherungsweise konstant.

Da das Verhältnis zwischen den summierten Kontaktflächenbereichen mit zweitem Material und den summierten Kontaktflächenbereichen mit erstem Material auf den neu entstehenden Kontaktflächen im Fall der zweiten Untervariante höher als im Fall der ersten Untervariante liegt, können die Abstände zwischen den einzelnen Durchgangsbohrungen 5 zur Erzielung eines gleich hohen elektrischen Übergangswiderstandes in der zweiten Untervariante größer als bei der ersten Untervariante gewählt werden. Somit sind in der zweiten Untervariante entsprechend weniger Durchgangsbohrungen 5 als im Fall der ersten Untervariante vorzusehen.

Neben einer regulären Anordnung der einzelnen Durchgangsbohrungen 5 innerhalb des jeweiligen Kontaktbereiches 2₁ bzw. 2₂ ist aber auch eine nicht reguläre, d.h. eine stochastische, Anordnung der einzelnen Durchgangsbohrungen 5 möglich und von der Erfindung mit abgedeckt. Die stochastische Anordnung der einzelnen Durchgangsbohrungen 5 garantiert auch ein näherungsweise konstantes Verhältnis zwischen den summierten Kontaktflächenbereichen aus ersten Material und den summierten Kontaktflächenbereichen aus zweitem Material bzw. aus Beschichtungsmaterial in jeder durch Abtrag neu entstandenen Kontaktfläche eines Kontaktbereiches. Damit wird auch ein näherungsweise gleich bleibender elektrischer Übergangswiderstand der Kontaktfläche eines Kontaktbereiches über die gesamte Betriebsdauer des elektrischen Kontaktelements erzielt.

Auch müssen die einzelnen Durchgangsbohrungen 5, wie in den Figuren dargestellt ist, nicht zwingend parallel zueinander angeordnet sein, sondern können auch bis zu einem bestimmten Grad in einer bestimmten Winkelorientierung zueinander angeordnet sein.

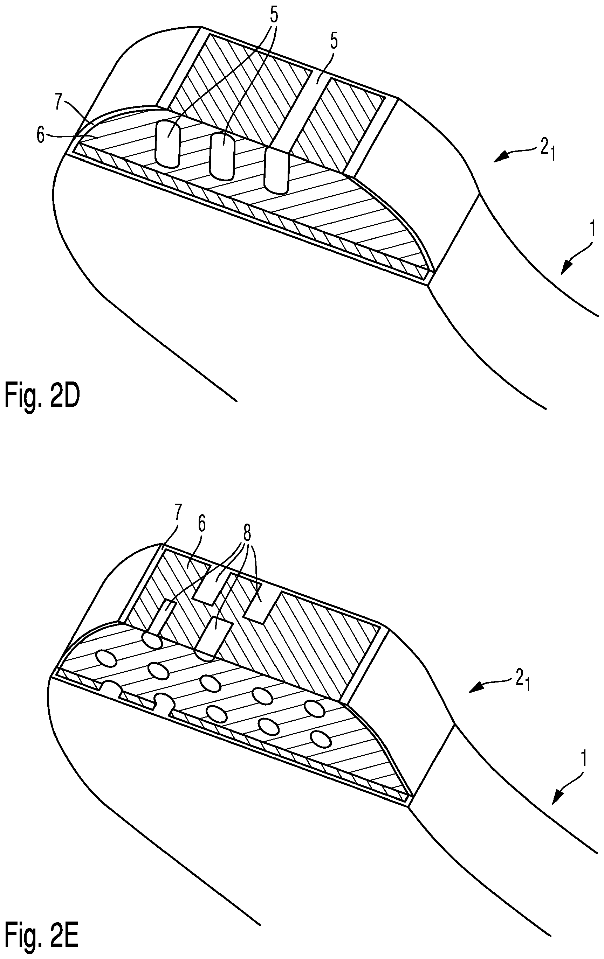

Neben Durchgangsbohrungen 5 mit einem kreisförmigen Querschnittsprofil gemäß der Figuren 2A und 2C sind auch Durchgangsbohrungen 5 mit einem Langloch-Querschnittsprofil möglich, wie sie in Fig. 2B für die erste Untervariante der ersten Ausführungsform des erfindungsgemäßen elektrischen Kontaktelements 1 und in Fig. 2D für die zweite Untervariante der ersten Ausführungsform dargestellt sind. Sind die einzelnen parallel angeordneten Durchgangsbohrungen 5 mit Langloch-Profil in Richtung der längeren Profilerstreckung zueinander versetzt angeordnet, wie den Figuren 2B und 2D angedeutet ist, so ergibt sich bei der jeweils neu entstehenden Kontaktfläche über die gesamte Betriebsdauer des elektrischen Kontaktelements vorteilhaft ein gleich bleibendes Verhältnis zwischen den summierten Kontaktflächenbereichen aus dem erstem Material und den summierten Kontaktflächenbereichen aus dem zweitem Material und aus Beschichtungsmaterial. Der elektrische Übergangswiderstand der jeweils neu entstandenen Kontaktfläche eines Kontaktbereiches bleibt somit über die Betriebsdauer des elektrischen Kontaktelements konstant.

Neben Durchgangsbohrungen 5 mit kreisförmigen Querschnittsprofil oder Langloch-Querschnittsprofil sind auch andere Querschnittsprofile, beispielsweise quadratische, rechteckförmige, elliptische oder sonstige Querschnittsprofile, möglich und von der Erfindung mit abgedeckt.

Neben der bevorzugten Verwendung von Durchgangsbohrungen 5 sind auch Sacklochbohrungen 8 möglich und von der Erfindung mit abgedeckt. Gemäß Fig. 2E verlaufen hierbei Sacklochbohrungen 8 im Grundkörper 6 innerhalb eines Kontaktbereiches 2₁ bzw. 2₂ von einer Außenfläche des Grundkörpers 6, die senkrecht zu einer zur jeweiligen Kontaktfläche 3₁ bzw. 3₂ benachbarten Außenfläche des elektrischen Kontaktelements 1 verläuft, bis ins Innere des Grundkörpers und endet im Innern des Grundkörpers. Um bei einem Abtrag des erfindungsgemäßen elektrischen Kontaktelements 1 eine möglichst gleichmäßige Verteilung der summierten Kontaktflächenbereiche aus ersten Material und der summierten Kontaktflächenbereiche aus zweitem Material und aus Beschichtungsmaterial auf den jeweils neu entstandenen Kontaktflächen zu erzielen, sind wie in Fig. 2E dargestellt die Sacklochbohrungen in jeder zur jeweiligen Kontaktfläche 3₁ bzw. 3₂ parallelen Ebene jeweils im Wechsel von einer der beiden gegenüberliegenden Außenflächen des elektrischen Kontaktelements 1 in den Grundkörper 6 einzuführen.

Liegt eine Sacklochbohrung 8 vor, die äquivalent zur Durchgangsbohrung 5 der Fig. 2A und 2B nur teilweise mit einem zweiten Material aufgefüllt ist, so ist auch der Bereich der Beschichtung 7 an der Außenfläche des erfindungsgemäßen elektrischen Kontaktelements 1, der sich an den vom zweiten Material befreiten Bereich der Sacklochbohrung 8 anschließt, nicht mit Beschichtungsmaterial ausgefüllt.

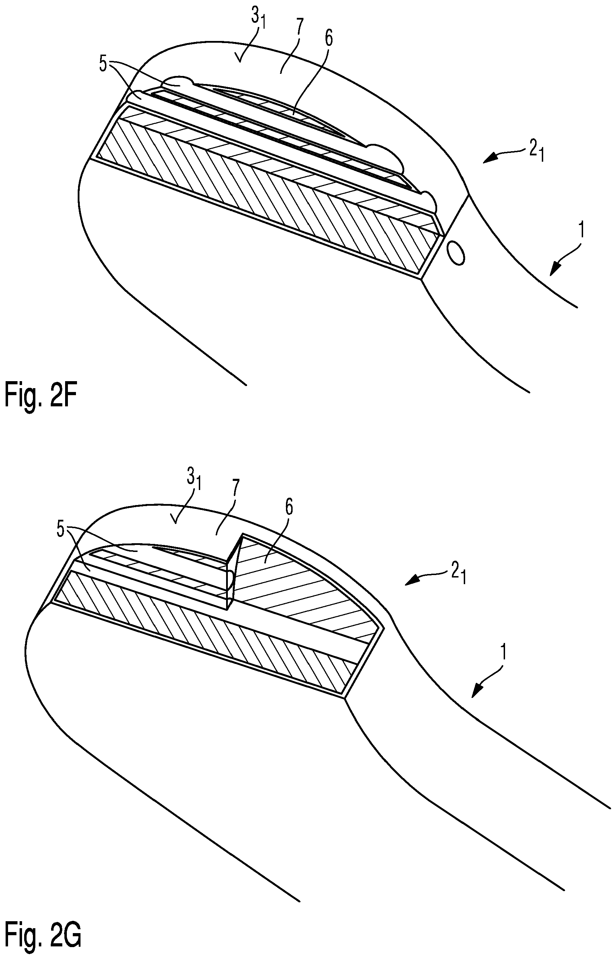

Aus den Fig. 2F und 2G gehen jeweils ebenfalls Durchgangsbohrungen 5 im Grundkörper 6 innerhalb des Kontaktbereiches 2₁ hervor, die näherungsweise parallel zur zugehörigen Kontaktfläche 3₁ verlaufen. Diese Durchgangsbohrungen 5 erstrecken sich gegenüber den in den Figuren 2A bis 2D dargestellten Durchgangsbohrungen 5 zwischen den beiden anderen, ebenfalls gegenüber liegenden Außenflächen des Grundkörpers 6, die jeweils senkrecht zur Kontaktfläche 3₁ orientiert sind.

Aufgrund der deutlich geringeren Breite dieser beiden gegenüberliegenden Außenflächen des elektrischen Kontaktelements 1 in Relation zur Breite der beiden anderen Außenflächen, durch die die Durchgangsbohrungen 5 gemäß der Figuren 2A bis 2D verlaufen, ist hierbei die Anzahl der Durchgangsbohrungen 5 in jeder Ebene parallel zur Kontaktfläche 3₁ deutlich reduziert und bevorzugt auf eine Durchgangsbohrung 5 pro Ebene beschränkt.

In Fig. 2F sind Durchgangsbohrungen 5 dargestellt, in denen jeweils einzig die Innenwandung mit zweitem Material beschichtet ist, während aus Fig. 2G Durchgangsbohrungen 5 hervorgehen, in denen das erste Material des Grundkörpers 6 vollständig durch zweites Material ersetzt ist.

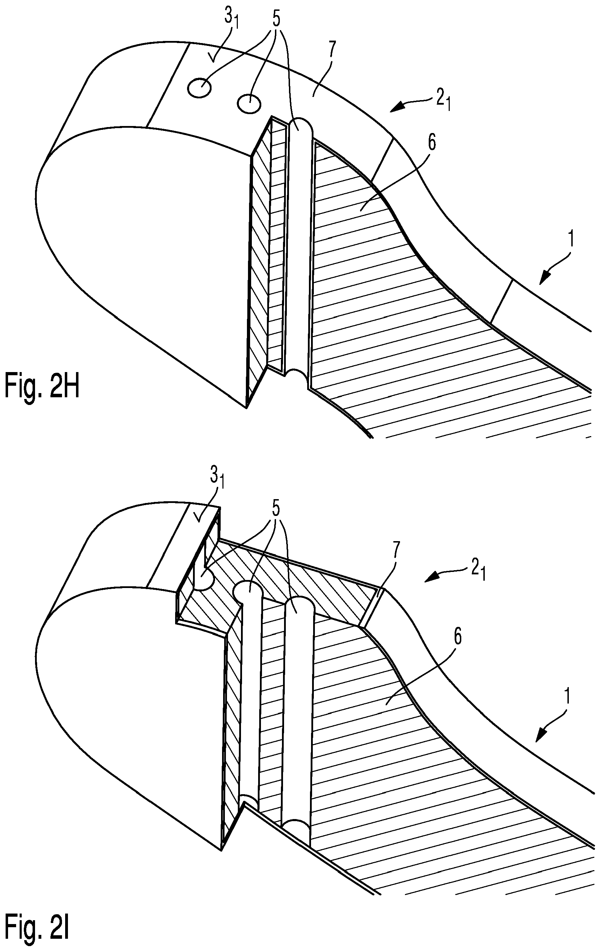

Aus den Fig. 2H und 2I sind schließlich Durchgangsbohrungen 5 ersichtlich, die senkrecht zur Kontaktfläche 3₁ des Kontaktbereichs 2₁ von jeweils einer zur Kontaktfläche 3₁ des erfindungsgemäßen elektrischen Kontaktelements 1 parallelen Außenfläche des Grundkörpers 6 zu einer jeweils gegenüber liegende Außenfläche des Grundkörpers 6 verlaufen.

In Fig. 2H sind Durchgangsbohrungen 5 einer ersten Untervariante der ersten Ausführungsform des erfindungsgemäßen elektrischen Kontaktelements 1 dargestellt, bei denen einzig die Innenwandung der einzelnen Durchgangsbohrung 5 jeweils mit zweitem Material beschichtet ist. Äquivalent zu den Durchgangsbohrungen 5 der Fig. 2A und 2B, die nur teilweise mit einem zweiten Material aufgefüllt sind, sind auch bei den Durchgangsbohrungen 5 der Fig. 2H die Bereiche der Beschichtung 7 an den beiden Außenflächen des erfindungsgemäßen elektrischen Kontaktelements 1, die sich an den vom zweiten Material befreiten Bereich der jeweiligen Durchgangsbohrung 5 jeweils anschließen, nicht mit Beschichtungsmaterial ausgefüllt.

Aus Fig. 2I gehen dagegen Durchgangsbohrungen 5 einer zweiten Untervariante der ersten Ausführungsform des erfindungsgemäßen elektrischen Kontaktelements 1 hervor, in denen das erste Material des Grundkörpers 6 vollständig durch zweites Material ersetzt ist.

Der technische Vorteil einer Ausprägung der Durchgangsbohrungen gemäß der Fig. 2H und 2I liegt darin, dass aufgrund des kontinuierlichen Verlaufs der einzelnen Durchgangsbohrungen 5 im Kontaktbereich 2₁ das Verhältnis zwischen den summierten Kontaktflächenbereichen aus ersten Material und den summierten Kontaktflächenbereichen aus zweiten Material und aus Beschichtungsmaterial bei den neu entstandenen Kontaktflächen während der gesamten Betriebsdauer des erfindungsgemäßen elektrischen Kontaktelements 1 und damit der elektrische Übergangswiderstand im Kontaktbereich 2₁ stets konstant bleibt. Die Anordnung und die Anzahl der einzelnen Durchgangsbohrungen 5 im Kontaktbereich 2₁ ist so auszuwählen, dass einerseits ein ausreichender elektrischer Übergangswiderstand im Kontaktbereichs 2₁ während der gesamten Betriebsdauer des erfindungsgemäßen elektrischen Kontaktelements 1 und andererseits eine ausreichende mechanische Stabilität des erfindungsgemäßen elektrischen Kontaktelements 1 im Kontaktbereich 2₁ gewährleistet ist.

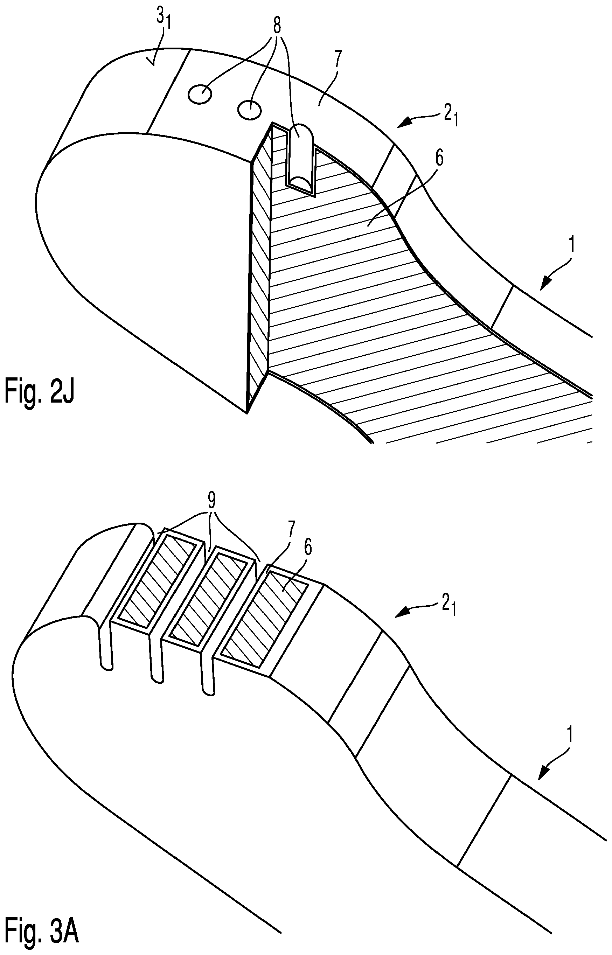

In Fig. 2J sind Sacklochbohrungen 8 dargestellt, die jeweils von einer Außenfläche des Grundkörpers 6, die parallel zur Kontaktfläche 3₁ des Kontaktbereichs 2₁ verläuft, in den Grundkörper 6 hineinreichen und bei einer bestimmten Tiefe im Grundkörper 6 enden. Die Bereiche der Beschichtung 7 an der Außenflächen des erfindungsgemäßen elektrischen Kontaktelements 1, die sich an die vom zweiten Material befreiten Bereiche der einzelnen Sacklochbohrungen 8 jeweils anschließen, sind nicht mit Beschichtungsmaterial ausgefüllt.

Die Tiefe der einzelnen Sacklochbohrungen 8 ist so zu bemessen, dass trotz eines Abtrages über die gesamte Betriebsdauer des erfindungsgemäßen elektrischen Kontaktelements 1 die jeweils neu entstehende Kontaktfläche noch Flächenbereiche mit dem in den einzelnen Sacklochbohrungen 8 jeweils vorhandenen zweiten Material enthält.

In einer zweiten Ausführungsform des erfindungsgemäßen Kontaktelements 1 ist in jedem Kontaktbereich ausgehend von der zugehörigen Kontaktfläche jeweils mindestens ein Schlitz 9 vorgesehen, der jeweils in den Grundkörper 6 hineinreicht. Bevorzugt sind mehrere parallele Schlitze 9 mit einer bestimmten Schlitzbreite, einer bestimmten Schlitztiefe und einer bestimmten Längserstreckung von einer Außenfläche des erfindungsgemäßen Kontaktelements, die zur Kontaktfläche 3₁ bzw. 3₂ des jeweiligen Kontaktbereiches 2₁ und 2₂ benachbart ist, zur gegenüberliegenden Außenfläche vorgesehen.

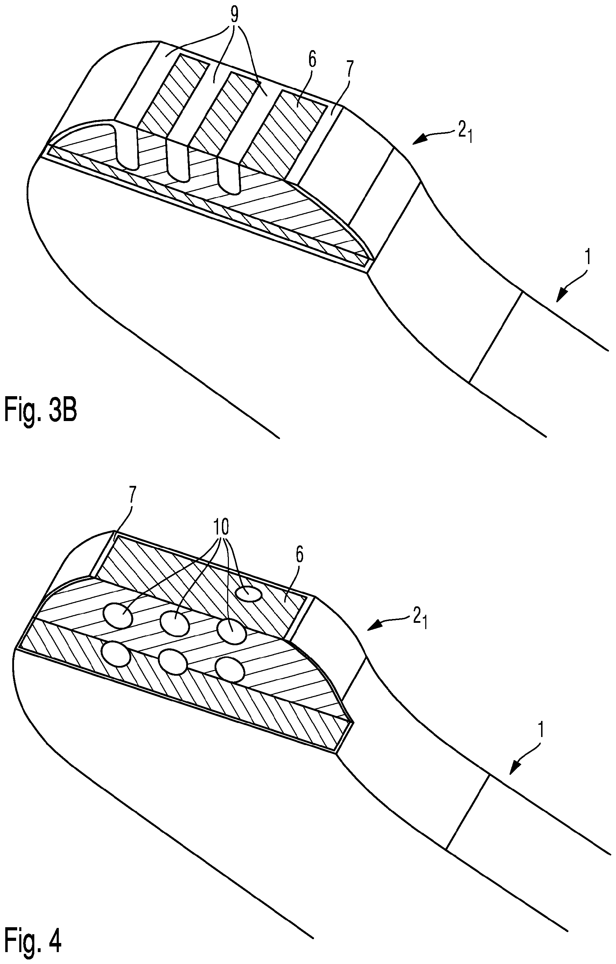

In einer ersten Untervariante der zweiten Ausführungsform gemäß Fig. 3A ist der einzelne Schlitz nur teilweise mit zweitem Material ausgefüllt. Insbesondere ist die Innenwandung des einzelnen Schlitzes 9 mit zweitem Material beschichtet. In einer zweiten Untervariante der zweiten Ausführungsform gemäß der Fig. 3B ist der einzelne Schlitz 9 vollständig mit zweitem Material ausgefüllt.

Die Schlitztiefe der einzelnen Schlitze 9 ist wiederum derart zu bemessen, dass über die gesamte Betriebsdauer des erfindungsgemäßen elektrischen Kontaktelements 1 die durch Abtrag jeweils neu entstandenen Kontaktflächen jeweils stets Kontaktflächenbereiche aus zweitem Material enthalten.

Die Schlitzbreite der einzelnen Schlitze 9, die Anzahl der parallelen Schlitze 9 und im Fall der ersten Untervariante der zweiten Ausführungsform die Beschichtungsdicke des zweiten Materials innerhalb der einzelnen Schlitze 9 sind hierbei so zu bemessen, dass bei einem Abtrag des erfindungsgemäßen Kontaktelements 1 die jeweils neu entstandenen Kontaktflächen jeweils ein Verhältnis der summierten Kontaktflächenbereiche aus erstem Material zu den summierten Kontaktflächenbereichen aus zweiten Material und aus Beschichtungsmaterial aufweisen, das einen ausreichend kleinen elektrischen Übergangswiderstand im jeweiligen Kontaktbereich gewährleistet.

Der mindestens eine Schlitz 9 kann jeweils eine Längsorientierung aufweisen, die, wie in den Fig. 3A und 3B dargestellt ist, zwischen den beiden gegenüberliegenden Außenflächen des erfindungsgemäßen elektrischen Kontaktelements 1, die an die Kontaktfläche 2₁ angrenzen und jeweils den kleineren Abstand zueinander aufweisen. Alternativ kann der mindestens eine Schlitz 9 äquivalent zum Verlauf der Durchgangsbohrungen 5 in den Fig. 2F und 2G auch zwischen den beiden gegenüberliegenden Außenflächen des erfindungsgemäßen Kontaktelements 1 verlaufen, die an die Kontaktfläche 2₁ angrenzen und jeweils den größeren Abstand zueinander aufweisen.

In einer dritten Ausführungsform des erfindungsgemäßen elektrischen Kontaktelements 1 gemäß Fig. 4 ist der mindestens eine Bereich innerhalb des jeweiligen Kontaktbereiches 2₁ bzw. 2₂, in dem jeweils das erste Material des Grundkörpers 6 durch zweites Material ersetzt ist, jeweils ein einzig innerhalb des Grundkörpers 6 befindlicher dreidimensionaler Körper 10. Bevorzugt sind innerhalb des jeweiligen Kontaktbereiches 2₁ bzw. 2₂ jeweils mehrere dreidimensionale Körper 10 vorgesehen, die entweder in einer regulären Anordnung, beispielsweise in einem bestimmten Raster, oder in einen nicht regulären Anordnung, d.h. stochastisch verteilt, vorliegen.

Die einzelnen dreidimensionalen Körper 10 können jeweils eine reguläre geometrische Form, beispielsweise eine Kugel, ein Würfel, ein Quader, ein Ellipsoid usw., oder eine andere beliebige nicht reguläre geometrische Form aufweisen. Die Größe der einzelnen dreidimensionalen Körper 10, beispielsweise der Durchmesser eines kugelförmigen Körpers, ist bevorzugt gleich bzw. liegt in der gleichen Größenordnung. Alternativ können die einzelnen dreidimensionalen Körper 10 auch eine unterschiedliche Größe aufweisen und jeweils eine unterschiedliche geometrische Form annehmen.

Generell ist die Anzahl, die Anordnung, die geometrische Form und die Größe der einzelnen dreidimensionaler Körper 10 so zu wählen, dass über die gesamte Betriebsdauer des erfindungsgemäßen elektrischen Kontaktelements 1 die durch einen Abtrag neu entstandenen Kontaktflächen des jeweiligen Kontaktbereiches jeweils ein Verhältnis der summierten Kontaktflächenbereiche aus erstem Material zu den summierten Kontaktflächenbereichen aus zweitem Material und aus Beschichtungsmaterial aufweisen, das näherungsweise ein gleichbleibender elektrischer Übergangswiderstand im jeweiligen Kontaktbereich gewährleistet ist.

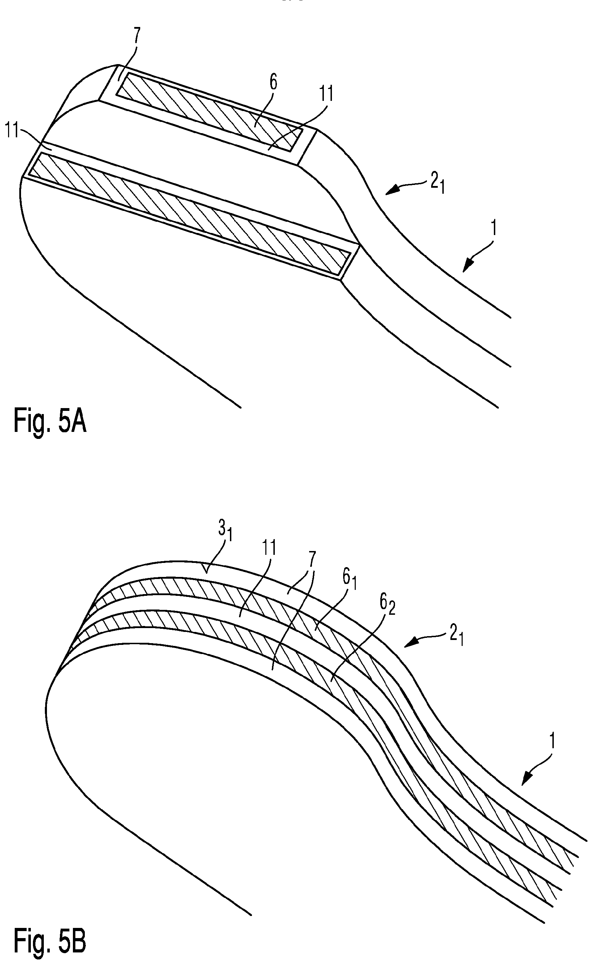

In einer vierten Ausführungsform des erfindungsgemäßen elektrischen Kontaktelements 1 ist der mindestens eine Bereich im Grundkörper 6 innerhalb des jeweiligen Kontaktbereiches 2₁ und 2₂, in dem das erste Material durch ein zweites Material mit einer gegenüber dem ersten Material höheren elektrischen Leitfähigkeit ersetzt ist, jeweils eine Schicht 11, die jeweils senkrecht zur Kontaktfläche 3₁ bzw. 3₂ des jeweiligen Kontaktbereiches 2₁ und 2₂ verläuft. Bevorzugt sind mehrere parallel verlaufende Schichten 11 innerhalb des erfindungsgemäßen elektrischen Kontaktelements 1 vorgesehen. Alternativ ist aber auch, wie in Fig. 5A dargestellt ist, eine einzige Schicht 11 innerhalb des erfindungsgemäßen elektrischen Kontaktelements 1 möglich und von der Erfindung mit abgedeckt.

Die mindestens eine Schicht 11 kann sich nur innerhalb des jeweiligen Kontaktbereiches 2₁ bzw. 2₂ des erfindungsgemäßen elektrischen Kontaktelements 1 erstrecken. Bevorzugt erstreckt sich die mindestens eine Schicht 11 über das gesamte erfindungsgemäße elektrische Kontaktelement 1, wie in Fig. 5B dargestellt ist. Hierbei ist zur vereinfachten Veranschaulichung des Verlaufs der Schicht 11 die Beschichtung 7 auf der schmalen umlaufenden Stirnfläche nicht dargestellt. Der Grundkörper 6 des erfindungsgemäßen elektrischen Kontaktelements 1 ergibt sich dabei, wie in Fig. 5B dargestellt ist, aus mehreren Schichten 6₁ und 6₂ aus erstem Material, die jeweils parallel zur mindestens einen Schicht 11 aus zweitem Material verlaufen.

Liegt ein mikromechanisches Kontaktelement vor, so können die einzelnen Schichten aus erstem Material bzw. aus zweitem Material mittels geeigneter Aufbautechnologie, beispielsweise durch wechselnde galvanische Abscheidung des ersten und des zweiten Materials, hergestellt werden. Liegt ein elektrisches Kontaktelement mit einer größeren Ausdehnung vor, so sind die einzelnen Schichten entweder mit konventioneller Zerspanungs- oder Gusstechnik herzustellen und anschließend mit einer geeigneten Verbindungstechnik, beispielsweise mittels Schnappverbindung, Verstiften, Löten, Kleben, Schrauben, miteinander zu verbinden.

In einer weiteren Ausprägung der vierten Ausführungsform des erfindungsgemäßen elektrischen Kontaktelements 1 sind die einzelnen parallelen Schichten 11 aus zweitem Material und die dazwischen angeordneten Schichten 6₁, 6₂,.... aus erstem Material auch in einer Orientierung einerseits senkrecht zur jeweiligen Kontaktfläche 3₁ und 3₂ des jeweiligen Kontaktbereiches 2₁ bzw. 2₂ und andererseits senkrecht zur Orientierung der Schicht 11 aus zweitem Material und der Schichten 6₁ und 6₂ aus erstem Material gemäß der Fig. 5A und 5B anzuordnen. In diesem Fall ist die Schichtfolge der Schichten aus zweitem Material und der Schichten 6₁ und 6₂ aus erstem Material einzig auf den jeweiligen Kontaktbereich 2₁ bzw. 2₂ des erfindungsgemäßen Kontaktelements 1 beschränkt.

Die Dicke der einzelnen Schichten 11 aus zweitem Material in Relation zur Dicke der einzelnen Schichten 6₁, 6₂,.... aus erstem Material ist so zu wählen, dass im jeweiligen Kontaktbereich 2₁ bzw. 2₂ jeweils ein ausreichend kleiner elektrischer Übergangswiderstand vorliegt. Bevorzugt ist fertigungsbedingt die Dicke der einzelnen Schichten 11 aus zweitem Material gleich auszulegen. Alternativ sind aber auch unterschiedliche Dicken der einzelnen Schichten 11 aus zweiten Material möglich und von der Erfindung mit abgedeckt. Insbesondere ist die Dicke der Schichten 11 aus zweitem Material in der Nähe der Beschichtung 7 des erfindungsgemäßen elektrischen Kontaktelements 1 größer als die Dicke der Schichten 11 aus zweitem Material im Zentrum des erfindungsgemäßen elektrischen Kontaktelements 1 auszulegen.

### Bezugszeichenliste

- 1: Kontaktelement
- 2₁, 2₂: Kontaktbereiche
- 3₁, 3₂: Kontaktfläche
- 4: Verbindungsbereich
- 4₁, 4₂: Federarme
- 5: Durchgangsbohrung
- 6: Grundkörper
- 6₁, 6₂: Schichten des Grundkörpers
- 7: Beschichtung
- 8: Sacklochbohrung
- 9: Schlitz
- 10: dreidimensionaler Körper
- 11: Schicht

## Patentansprüche

1. Elektrisches Kontaktelement (1), das mehrere Kontaktbereiche (2₁, 2₂) mit jeweils einer Kontaktfläche (3₁, 3₂) aufweist, mit einem Grundkörper (6) aus einem ersten Material und einer auf dem ganzen Grundkörper (6) aufgebrachten Beschichtung (7) aus einem Beschichtungsmaterial, wobei in mindestens einem Bereich des Grundkörpers (6) innerhalb von mindestens einem Kontaktbereich (2₁, 2₂) jeweils das erste Material entfernt ist und zumindest teilweise durch ein zweites Material ersetzt ist, wobei das Beschichtungsmaterial und das zweite Material jeweils eine höhere elektrische Leitfähigkeit als das erste Material aufweisen, wobei das Beschichtungsmaterial und das zweite Material eine geringere Härte als das erste Material aufweist.

2. Elektrisches Kontaktelement (1) nach Patentanspruch 1,
**dadurch gekennzeichnet,**
**dass** das zweite Material das Beschichtungsmaterial ist.

3. Elektrisches Kontaktelement (1) nach Patentanspruch 1,
**dadurch gekennzeichnet,**
**dass** das zweite Material ein zum Beschichtungsmaterial unterschiedliches Material ist.

4. Elektrisches Kontaktelement (1) nach einem der Patentansprüche 1 bis 3,
**dadurch gekennzeichnet,**
**dass** eine neu entstandene Kontaktfläche, die durch einen Abtrag einer zum jeweiligen Kontaktbereich (2₁, 2₂) jeweils gehörenden Kontaktfläche (3₁, 3₂) entsteht, Kontaktflächenbereiche aus dem zweiten Material und dem Beschichtungsmaterial enthält, die in Summe gegenüber den summierten, zur Beschichtung (7) jeweils gehörenden Kontaktflächenbereichen der neu entstandenen Kontaktfläche vergrößert sind.

5. Elektrisches Kontaktelement (1) nach einem der Patentansprüche 1 bis 4,
**dadurch gekennzeichnet,**
**dass** der mindestens eine Bereich jeweils eine im Grundkörper (6) befindliche Sacklochbohrung (8) oder Durchgangsbohrung (5) ist.

6. Elektrisches Kontaktelement (1) nach einem der Patentansprüche 1 bis 4,
**dadurch gekennzeichnet,**
**dass** der mindestens eine Bereich jeweils ein von der Kontaktfläche (3₁, 3₂) des jeweiligen Kontaktbereiches (2₁, 2₂) in den Grundkörper (6) hineinreichender Schlitz (9) ist.

7. Elektrisches Kontaktelement (1) nach Patentanspruch 5 oder 6,
**dadurch gekennzeichnet,**
**dass** die Durchgangsbohrung (5) oder die Sacklochbohrung (8) oder der Schlitz (9) jeweils vollständig mit dem zweiten Material ausgefüllt ist.

8. Elektrisches Kontaktelement (1) nach Patentanspruch 5 oder 6,
**dadurch gekennzeichnet,**
**dass** die Durchgangsbohrung (5) oder die Sacklochbohrung (8) oder der Schlitz (9) jeweils mit dem zweiten Material beschichtet ist.

9. Elektrisches Kontaktelement (1) nach einem der Patentansprüche 1 bis 4,
**dadurch gekennzeichnet,**
**dass** der mindestens eine Bereich jeweils eine im Grundkörper (6) verlaufende Schicht (11) ist.

10. Elektrisches Kontaktelement (1) nach einem der Patentansprüche 1 bis 4,
**dadurch gekennzeichnet,**
**dass** der mindestens eine Bereich jeweils ein im Grundkörper (6) befindlicher Hohlraum (10) ist, der mit dem zweiten Material gefüllt ist.

## Claims

1. An electrical contact element (1), which has a plurality of contact regions (2₁, 2₂), with in each case a contact surface (3₁, 3₂), comprising a basic body (6) made of a first material and a coating (7) made of a coating material applied to the entire basic body (6), wherein in at least one region of the basic body (6) within at least one contact region (2₁, 2₂) in each case the first material is removed and is replaced at least partially by a second material, wherein the coating material and the second material in each case have a higher electrical conductivity than the first material, wherein the coating material and the second material has a lower hardness than the first material.

2. The electrical contact element (1) according to patent claim 1,
**characterized in**
**that** the second material is the coating material.

3. The electrical contact element (1) according to patent claim 1,
**characterized in**
**that** the second material is a material different from the coating material.

4. The electrical contact element (1) according to any one of patent claims 1 to 3,
**characterized in**
**that** a newly created contact surface, which is produced by a removal of a contact surface (3₁, 3₂) belonging in each case to the respective contact region (2₁, 2₂), contains contact surface regions made of the second material and the coating material, which in total are enlarged compared to the summed contact surface regions of the newly created contact surface belonging in each case to the coating (7).

5. The electrical contact element (1) according to any one of patent claims 1 to 4,
**characterized in**
**that** the at least one region is in each case a blind-hole bore (8) or through bore (5) located in the basic body (6).

6. The electrical contact element (1) according to any one of patent claims 1 to 4,
**characterized in**
**that** the at least one region in each case is a slot (9) extending from the contact surface (3₁, 3₂) of the respective contact region (2₁, 2₂) into the basic body (6).

7. The electrical contact element (1) according to patent claim 5 or 6,
**characterized in**
**that** the through bore (5) or the blind-hole bore (8) or the slot (9) is in each case completely filled with the second material.

8. The electrical contact element (1) according to patent claim 5 or 6,
**characterized in**
**that** the through bore (5) or the blind-hole bore (8) or the slot (9) is in each case coated with the second material.

9. The electrical contact element (1) according to any one of patent claims 1 to 4,
**characterized in**
**that** the at least one region is in each case a layer (11) running in the basic body (6).

10. The electrical contact element (1) according to any one of patent claims 1 to 4,
**characterized in**
**that** the at least one region is in each case a cavity (10) located in the basic body (6), which cavity is filled with the second material.

## Revendications

1. Élément de contact électrique (1), qui comprend plusieurs zones de contact (2₁, 2₂) chacune avec une surface de contact (3₁, 3₂), avec un corps de base (6) constitué d'un premier matériau et un revêtement (7) appliqué sur tout le corps de base (6), constitué d'un matériau de revêtement, moyennant quoi, dans au moins une zone du corps de base (6), à l'intérieur d'au moins une zone de contact (2₁, 2₂), le premier matériau étant enlevé et remplacé au moins partiellement par un deuxième matériau, le matériau de revêtement et le deuxième matériau présentant chacun une conductivité électrique supérieure à celle du premier matériau, le matériau de revêtement et le deuxième matériau présentant une dureté inférieure à celle du premier matériau.

2. Élément de contact électrique (1) selon la revendication 1,
**caractérisé en ce que**
le deuxième matériau est le matériau de revêtement.

3. Élément de contact électrique (1) selon la revendication 1,
**caractérisé en ce que**
le deuxième matériau est un matériau différent du matériau de revêtement.

4. Élément de contact électrique (1) selon l'une des revendications 1 à 3,
**caractérisé en ce que**
une surface de contact nouvellement créée, qui apparaît suite à l'enlèvement d'une surface de contact (3₁, 3₂) appartenant à la zone de contact (2₁, 2₂) correspondante, comprend des zones de surface de contact constituées du deuxième matériau et du matériau de revêtement, qui sont agrandies, au total, par rapport aux zones de surface de contact additionnées, appartenant chacune au revêtement (7), de la surface de contact nouvellement créée.

5. Élément de contact électrique (1) selon l'une des revendications 1 à 4,
**caractérisé en ce que**
l'au moins une zone est respectivement un trou borgne (8) se trouvant dans le corps de base (6) ou un trou traversant (5).

6. Élément de contact électrique (1) selon l'une des revendications 1 à 4,
**caractérisé en ce que**
l'au moins une zone est respectivement une fente (9) pénétrant de la surface de contact (3₁, 3₂) de la zone de contact (2₁, 2₂) correspondante dans le corps de base (6).

7. Élément de contact électrique (1) selon la revendication 5 ou 6,
**caractérisé en ce que**
le trou traversant (5) ou le trou borgne (8) ou la fente (9) est rempli respectivement entièrement avec le deuxième matériau.

8. Élément de contact électrique (1) selon la revendication 5 ou 6,
**caractérisé en ce que**
le trou traversant (5) ou le trou borgne (8) ou la fente (9) est revêtu respectivement avec le deuxième matériau.

9. Élément de contact électrique (1) selon l'une des revendications 1 à 4,
**caractérisé en ce que**
l'au moins une zone est une couche (11) s'étendant respectivement dans le corps de base (6).

10. Élément de contact électrique (1) selon l'une des revendications 1 à 4,
**caractérisé en ce que**
l'au moins une zone est respectivement une cavité (10) se trouvant dans le corps de base (6), qui est remplie avec le deuxième matériau.
